# DEMANDE DE BREVET EUROPEEN

(11) **EP 2 284 839 A1**
(43) Date de publication de la demande: **16.02.2011**
(21) Numéro de dépôt: 10170405.4
(22) Date de dépôt: 22.07.2010
(51) Int. Cl.: G11C 11/412, G11C 11/419, G11C 7/12

(54) **Dispositif de mémoire statique à cinq transistors et procédé de fonctionnement.**

(30) Priorité: 28.07.2009 FR 0955274; 26.01.2010 FR 1050487
(71) Demandeur: STmicroelectronics SA, 92120 Montrouge (FR)
(72) Inventeur: Hamouche, Lahcen, 38100, GRENOBLE (FR); Lafont, Jean-Christophe, 38240, MEYLAN (FR)
(74) Mandataire: Zapalowicz, Francis

(57) **Abrégé**

Au bas d'une colonne (COLi) de cellules-mémoires (CEL) du type SRAM à cinq transistors sans port d'accès, on place une cellule supplémentaire (CLS), de structure identique aux cellules (CEL), qui permet l'écriture et la lecture d'une données dans une cellule-mémoire (CEL) de la colonne sans utiliser d'amplificateur de lecture.

## Description

L'invention concerne les circuits intégrés, et plus particulièrement les dispositifs de mémoires statiques, du type SRAM (« Static Random Access Memory »), à cinq transistors, dites « sans port d'accès », encore communément appelées par l'homme du métier sous la dénomination anglo-saxonne de « portless SRAM ».

Les cellules-mémoires du type SRAM à cinq transistors sans port d'accès sont bien connues de l'homme du métier. On peut citer notamment l'article de Michael Wieckowski et Martin Margala intitulé « Portless SRAM - A High-Performance Alternative to the 6T Methodology », IEEE Journal of Solid-State Circuits, volume 42, n°11, Novembre 2007, ou encore l'article de ces mêmes auteurs intitulé « A Portless SRAM Cell Using Stunted Wordline Drivers », IEEE 2008, pages 584-587.

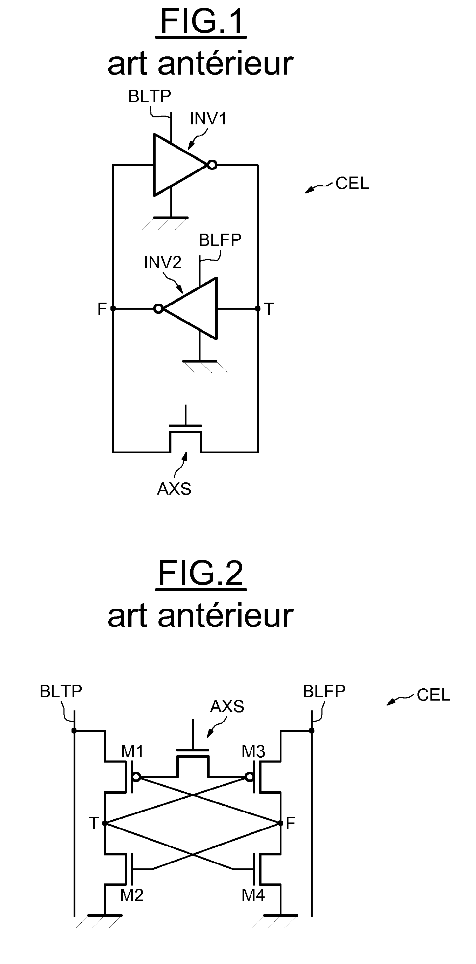

Une cellule-mémoire du type SRAM sans port d'accès est, comme illustré schématiquement sur la figure 1, basée sur le principe de deux inverseurs INV1, INV2, couplés de façon croisée et alimentés par deux lignes de bits BLTP et BLFP sans port d'accès, tels que par exemple des transistors NMOS.

En outre, la cellule SRAM comporte un cinquième transistor, dit « transistor d'accès », AXS, connecté comme illustré sur la figure 1.

La figure 2 illustre une représentation plus détaillée, mais toujours schématique, de la cellule de la figure 1, dans laquelle les transistors des inverseurs ont été représentés. Plus précisément, la cellule CEL comporte effectivement cinq transistors, à savoir deux paires de transistors PMOS et NMOS formant les deux inverseurs, ainsi que le cinquième transistor AXS. On voit sur la figure 2 que la source du transistor PMOS M1 est reliée à la ligne de bits BLTP, tandis que la source du transistor PMOS M3 est reliée à la ligne BLFP. Les drains de ces deux transistors M1 et M3 sont respectivement reliés aux drains des deux transistors NMOS M2 et M4. Les sources de ces deux transistors M2 et M4 sont reliées à la masse.

Par ailleurs, les grilles des quatre transistors M1-M4 sont couplées de façon croisée. Enfin, le transistor d'accès AXS, qui est ici un transistor NMOS, est connecté entre les grilles des transistors PMOS M1 et M3. Cela étant ce transistor AXS pourrait être un transistor PMOS.

Une donnée, formée de deux valeurs logiques complémentaires 1,0 ou 0,1 est stockée entre les deux noeuds de sortie T et F des deux inverseurs.

Lorsque le transistor d'accès AXS est ouvert (bloqué), la cellule CEL est stable et la donnée est maintenue dans cette cellule tant que la cellule reste alimentée par la tension d'alimentation. Lorsque le transistor d'accès AXS est fermé (passant), un courant circule depuis le noeud T ou F présentant la valeur logique 1 vers le noeud F ou T présentant la valeur logique 0.

Une cellule SRAM à cinq transistors sans port d'accès est donc une alternative aux cellules SRAM classiques à six transistors, c'est-à-dire à deux inverseurs connectés aux deux lignes de bits par deux ports d'accès tels que des transistors NMOS.

Pour écrire une donnée dans la cellule CEL, on précharge tout d'abord les deux lignes de bits à la tension d'alimentation, on ferme le transistor AXS puis on fait chuter la tension de l'une des lignes de bits selon que l'on désire écrire un 1 ou un 0, de façon à provoquer une différence de tension entre les noeuds T et F de la cellule.

Une fois que la donnée est écrite, on réouvre le transistor AXS et on réactive la précharge qui assure l'alimentation de la cellule nécessaire à la conservation de la donnée.

Pour lire la donnée dans la cellule CEL on ferme le transistor AXS. Il se crée alors une différence de courant entre les deux lignes de bits, dont le signe dépend de la valeur logique de la donnée stockée. Cette différence de courant est amplifiée de façon classique dans un amplificateur de courant situé en bas de la colonne du plan-mémoire contenant la cellule, et la donnée est ainsi lue.

Une telle colonne classique de cellules-mémoires SRAM à cinq transistors sans port d'accès présente un certain nombre d'inconvénients.

Plus précisément, durant une opération d'écriture, la différence de tension entre les deux lignes de bits doit être suffisamment importante pour permettre le changement d'état de la cellule à écrire, sans toutefois affecter la stabilité des autres cellules de la même colonne puisque toutes les cellules de la colonne sont alimentées par ces lignes de bits.

Par ailleurs, durant une opération de lecture, la cellule lue doit induire une différence de courant entre les deux lignes de bits suffisamment importante de façon à se situer en dehors de l'« offset » de l'amplificateur de courant situé en bas de la colonne.

Or, toutes ces contraintes s'avèrent en général incompatibles avec des technologies avancées dans lesquelles la tension d'alimentation est relativement basse, par exemple des technologies 45 nanomètres dans lesquelles la tension d'alimentation est de 1,1 volt.

Selon un mode de réalisation, il est proposé un dispositif de mémoire du type SRAM à cinq transistors sans port d'accès permettant de s'affranchir de l'utilisation d'un amplificateur de courant en bas de la colonne.

Il est également proposé, en particulier, un dispositif de mémoire de courant dynamique, donc une consommation moindre.

Il est également proposé, en particulier, d'effectuer les opérations d'écriture et de lecture dans les cellules au moyen d'un courant, ce qui ne nécessite pas les charges et décharges des lignes de bits dans les opérations d'écriture.

Selon un aspect, il est proposé un dispositif de mémoire du type SRAM, comprenant un plan-mémoire possédant au moins une colonne de cellules-mémoires du type SRAM comportant deux inverseurs couplés de façon croisée et un seul transistor d'accès, chaque cellule-mémoire étant connectée entre deux lignes de bits sans transistor d'accès.

Selon une caractéristique générale de cet aspect, chaque colonne du plan-mémoire comporte en outre une cellule supplémentaire, de structure identique aux cellules-mémoires de ladite colonne, cette cellule supplémentaire étant connectée également aux deux lignes de bits ; les deux lignes de bits sont destinées à être alimentées par une tension d'alimentation et le dispositif de mémoire comprend en outre des moyens d'accès supplémentaires, par exemple des transistors NMOS, commandables, connectés à ladite cellule supplémentaire et possédant un premier état pour interdire un accès à ladite cellule supplémentaire et un deuxième état pour permettre un accès à ladite cellule supplémentaire de façon à y stocker ou à en extraire une donnée.

Le dispositif comprend également des premiers moyens de commande configurés pour placer les moyens d'accès supplémentaires dans leur premier ou dans leur deuxième état ;

Le dispositif de mémoire comprend également des deuxièmes moyens de commande configurés pour, lorsque les moyens d'accès supplémentaires sont dans leur premier état, délivrer un premier signal de commande sur la grille du transistor d'accès de l'une des cellules-mémoires de la colonne et un deuxième signal de commande sur la grille du transistor d'accès de la cellule supplémentaire de façon à placer ladite cellule-mémoire dans un mode de lecture et la cellule-mémoire supplémentaire dans un mode d'écriture, ou inversement.

Ainsi, une cellule supplémentaire, située par exemple en bas de la colonne, identique aux cellules de la colonne, permet d'effectuer à la fois les opérations de lecture et les opérations d'écriture dans une cellule-mémoire sélectionnée de la colonne. Son rôle est simplement inversé entre une opération de lecture et une opération d'écriture. Plus précisément, lorsqu'une cellule devant être lue, est placée dans son mode de lecture, la cellule supplémentaire est placée dans son mode d'écriture, ce qui va permettre de recopier l'opposé (le complémentaire logique) de la donnée contenue dans la cellule à lire. Par contre, lorsqu'on doit écrire une donnée dans une cellule de la colonne, la cellule supplémentaire est alors placée dans la configuration de lecture, ce qui va permettre de recopier l'opposé de la donnée qu'elle contient dans la cellule de la colonne devant être écrite.

Ceci permet donc de s'affranchir d'un amplificateur de courant et donc des problèmes d'« offset » qui y sont liés.

On a une consommation dynamique faible puisque les courants de lecture de la cellule de la colonne devant être lue sont utilisés pour l'écriture dans la cellule supplémentaire. Enfin, il n'est nul besoin d'effectuer des charges et des décharges des lignes de bits à chaque opération d'écriture dans une cellule de la colonne.

Selon un mode de réalisation, les deuxièmes moyens de commande sont configurés pour délivrer sur la grille du transistor d'accès de la cellule-mémoire, une première tension en tant que premier signal de commande de façon à rendre passant ce transistor d'accès ; les deuxièmes moyens de commande sont également configurés pour délivrer sur la grille du transistor d'accès de la cellule-mémoire supplémentaire, une deuxième tension en tant que deuxième signal de commande de façon à rendre passant ce transistor d'accès ; la première tension est inférieure à la deuxième tension de façon à placer la cellule-mémoire dans le mode de lecture et la cellule-mémoire supplémentaire dans le mode d'écriture ; *a contrario,* la première tension est supérieure à la deuxième tension, de façon à placer la cellule-mémoire dans le mode écriture et la cellule-mémoire supplémentaire dans le mode lecture.

Cette différence entre les deux tensions appliquées sur les transistors d'accès de la cellule-mémoire de la colonne sélectionnée et de la cellule-mémoire supplémentaire, permet efficacement de placer l'une des cellules en mode de lecture et l'autre en mode d'écriture ou inversement, et d'éviter ainsi une incertitude dans le comportement de chacune des deux cellules.

De façon à corriger les dispersions liées à la technologie, notamment vis-à-vis de transistors PMOS plus rapides ou moins rapides que des transistors NMOS, et également de façon à pouvoir délivrer de façon simple les première et deuxième tensions de commande des transistors d'accès, il est avantageusement prévu que les deuxièmes moyens de commande comprennent des modules de commande respectivement associés aux cellules-mémoires de la colonne et à la cellule-mémoire supplémentaire ; chaque module de commande comporte par exemple une porte connectée entre la tension d'alimentation et la masse, la sortie de cette porte étant connectée à la grille du transistor d'accès de la cellule-mémoire correspondante, et les grilles des deux transistors de la porte étant respectivement commandées par un signal logique de lecture et un signal d'écriture ; le module de commande comporte également une pompe de charge connectée entre la tension d'alimentation et la grille du transistor d'accès par l'intermédiaire d'un transistor auxiliaire commandé sur sa grille par le signal logique d'écriture.

Un tel mode de réalisation permet ainsi de façon très simple, de délivrer sur la grille du transistor d'accès d'une cellule-mémoire, une tension inférieure à la tension d'alimentation lorsque cette cellule doit être en mode de lecture, et de délivrer sur la grille de ce transistor d'accès une tension supérieure à la tension d'alimentation lorsque cette cellule doit être en mode d'écriture.

Par ailleurs, de façon à encore améliorer le fonctionnement du dispositif de mémoire, et d'avoir un différentiel suffisamment grand pour permettre le changement d'état d'une cellule durant une opération d'écriture, il est avantageusement prévu que chaque inverseur d'une cellule-mémoire, et que chaque inverseur de la cellule-mémoire supplémentaire, soit connectés entre l'une des deux lignes de bits et une autre ligne de bits destinée à être connectée à la masse.

Selon un autre aspect, il est proposé un procédé de lecture d'une donnée contenue dans une cellule-mémoire d'un dispositif de mémoire tel que défini ci-avant, le procédé comprenant une connexion des deux lignes de bits à ladite tension d'alimentation, le placement des moyens d'accès supplémentaires de la cellule-mémoire supplémentaire dans leur premier état, le placement de la cellule-mémoire dans son mode lecture, le placement de la cellule-mémoire supplémentaire dans son mode écriture, l'opposée de la donnée contenue dans ladite cellule-mémoire étant écrite dans la cellule-mémoire supplémentaire, le placement des moyens d'accès supplémentaires dans leur deuxième état, et l'extraction de ladite donnée opposée de ladite cellule-mémoire supplémentaire.

Selon un autre aspect, il est proposé un procédé d'écriture d'une donnée dans une cellule-mémoire d'un dispositif tel que défini ci-avant, comprenant une connexion des deux lignes de bits à ladite tension d'alimentation, le placement des moyens d'accès supplémentaires de la cellule-mémoire supplémentaire dans leur deuxième état, le stockage de ladite donnée dans la cellule-mémoire supplémentaire, le placement des moyens d'accès supplémentaires dans leur premier état, le placement de la cellule-mémoire dans son mode écriture, le placement de la cellule-mémoire supplémentaire dans son mode lecture, l'opposée de la donnée contenue dans ladite cellule-mémoire supplémentaire étant écrite dans la cellule-mémoire.

D'autres avantages et caractéristiques de l'invention apparaîtront à l'examen de la description détaillée de modes de réalisation et de mise en oeuvre nullement limitatifs, et des dessins annexés, sur lesquels :
- les figures 1 et 2, déjà décrites, illustrent schématiquement une cellule-mémoire SRAM à cinq transistors sans port d'accès selon l'art antérieur ;
- la figure 3 illustre schématiquement un mode de réalisation d'un dispositif de mémoire selon l'invention ;
- les figures 4 et 5 illustrent respectivement les principales étapes de mode de mise en oeuvre d'une lecture et d'une écriture d'une donnée dans une cellule-mémoire d'une colonne du plan-mémoire d'un dispositif de mémoire selon l'invention ;
- la figure 6 illustre schématiquement mais plus en détails, une partie de moyens de commande d'un dispositif de mémoire selon l'invention, et
- les figures 7 à 14 illustrent schématiquement d'autres modes de réalisation et de mise en oeuvre de l'invention.

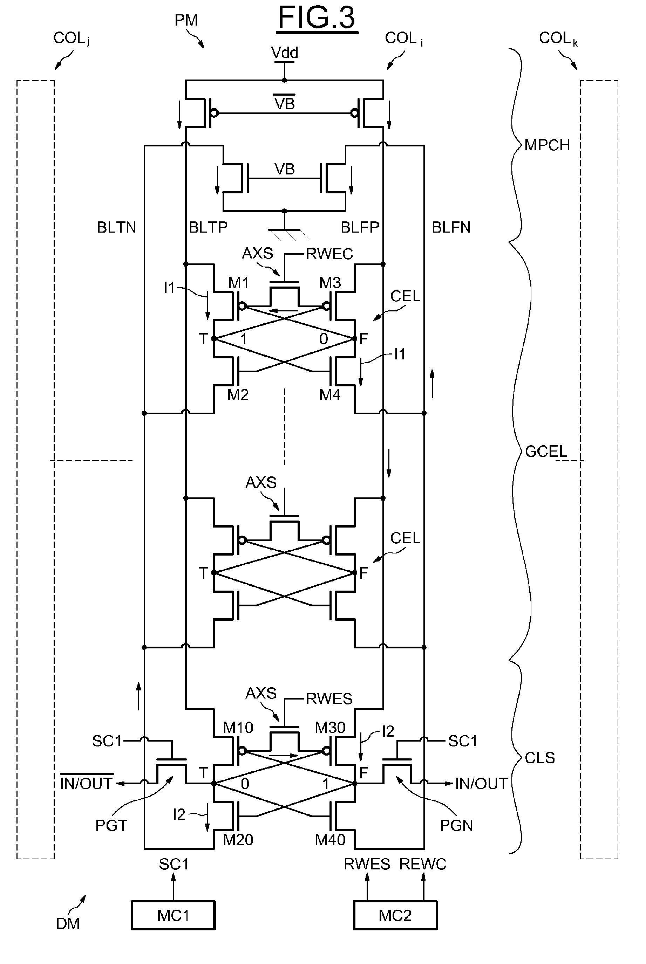

Sur la figure 3, un dispositif de mémoire DM comporte un plan-mémoire PM comportant une matrice de cellules-mémoires CEL du type SRAM à cinq transistors sans port d'accès telle que celle illustrée par exemple sur la figure 2. Le plan-mémoire PM comporte par conséquent des lignes de cellules-mémoires et des colonnes COL de cellules-mémoires CEL.

Seule la colonne COLi est illustrée en détails, la structure des autres colonnes COLj, COLk étant identique à celle de la colonne COLi.

Comme illustré sur la figure 3, chaque cellule-mémoire CEL de la colonne COLi est connectée aux deux lignes de bits BLTP et BLFP. Ces deux lignes de bits sont destinées à être connectées à la tension d'alimentation Vdd par l'intermédiaire de moyens MPCH comportant, dans cet exemple, deux transistors PMOS dont les grilles sont commandées par un signal logique V̅B̅.

Par ailleurs, les sources des transistors M2 et M4 de chacune des cellules CEL sont connectées respectivement à deux autres lignes de bits BLTN et BLFN destinées à être connectées à la masse par l'intermédiaire également des moyens MPCH, comportant en outre, à cet égard, deux transistors NMOS commandés par le signal logique VB.

Outre le groupe GCEL de cellules-mémoires CEL de la colonne, cette colonne comporte également une cellule-mémoire supplémentaire CLS de structure identique à une cellule-mémoire CEL du groupe GCEL. Cette cellule-mémoire supplémentaire CLS est donc également une cellule-mémoire statique à cinq transistors sans port d'accès entre les lignes de bits. En d'autres termes, comme pour les autres cellules-mémoires, les sources des transistors PMOS M10 et M30 de la cellule supplémentaire CLS sont directement connectées aux deux lignes de bits BLTP et BLFP sans port d'accès.

Par ailleurs, les sources des transistors NMOS M20 et M40 de la cellule supplémentaire CLS sont également connectées dans cet exemple aux deux autres lignes de bits BLTN BLFN.

Il est par ailleurs prévu des moyens d'accès supplémentaires PGT, PGN connectés aux deux noeuds de sortie T et F des deux inverseurs de la cellule supplémentaire CLS. Ces moyens d'accès supplémentaires PGT et PGN comportent ici deux transistors NMOS respectivement commandés sur leur grille par un signal de commande SC1.

Ce signal de commande SC1, selon sa valeur, va permettre de rendre passants ou bloqués les transistors PGT et PGN de façon à pouvoir accéder à la cellule supplémentaire CLS pour soit y stocker une donnée, soit en extraire une donnée.

Le signal de commande SC1 est délivré par des premiers moyens de commande MC1 pouvant être réalisés de façon classique et connue en soi, par exemple par des circuits logiques.

Le transistor d'accès AXS de chaque cellule CEL du groupe de cellules-mémoires GCEL est commandé sur la grille par un deuxième signal de commande RWEC qui est en fait une tension délivrée sur la grille de ce transistor d'accès AXS.

De même, la grille du transistor AXS de la cellule supplémentaire CLS reçoit en tant que deuxième signal de commande une tension RWES.

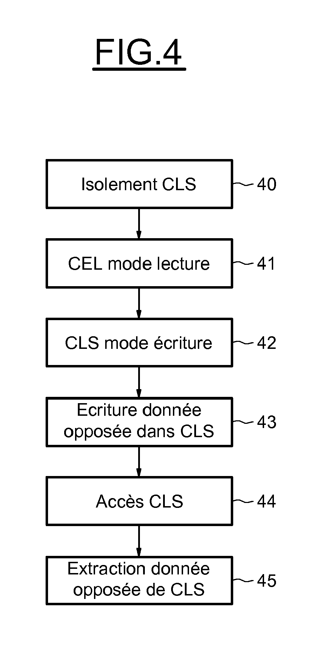

On se réfère maintenant plus particulièrement à la figure 4, pour décrire un mode de mise en oeuvre d'un procédé de lecture d'une donnée contenue dans une cellule-mémoire CEL de la colonne COLi. On suppose dans l'exemple décrit ici et illustré sur la figure 3, qu'un « 1 » logique est stocké dans la cellule CEL, caractérisé par exemple par la présence d'un « 1 » sur le noeud T et d'un « 0 » sur le noeud F.

La cellule CLS est isolée de l'extérieur par les transistors PGT et PGN, qui sont bloqués (étape 40, figure 4).

Les lignes de bits BLTP et NLFP sont connectées à la tension Vdd par l'intermédiaire des moyens MPCH (signal logique VB=1) tandis que les autres lignes de bits BLTN et BLFN sont connectées à la masse par l'intermédiaire des moyens MPCH (signal logique VB=1).

La tension RWEC, qui est ici une fraction de la tension d'alimentation Vdd (par exemple une fraction comprise entre 70 et 85% de cette tension d'alimentation), est appliquée sur la grille du transistor AXS de la cellule CEL (étape 41).

Parallèlement, une tension RWES égale ou de préférence supérieure à la tension Vdd est appliquée sur la grille du transistor AXS de la cellule CLS (étape 42).

Il en résulte donc que la cellule CLS est moins stable que la cellule CEL. En d'autres termes, la cellule CLS est dans un mode d'écriture tandis que la cellule CEL est dans un mode de lecture. De ce fait, comme illustré sur la figure 3, le sens du courant circulant dans le transistor AXS (qui est passant) de la cellule CEL est opposé au sens du courant traversant le transistor AXS de la cellule CLS.

Comme dans l'exemple illustré le noeud T de la cellule CEL est le noeud haut par rapport au noeud F qui est le noeud bas, un courant de lecture Il circule dans la cellule CEL comme illustré sur la figure 3.

De par cette opération de lecture, il se crée donc un différentiel de courant dans les lignes de bits BLTP et BLFP.

La cellule CLS, moins stable que la cellule CEL, va par conséquent induire un courant de sens opposé qui va circuler dans les lignes de bits BLTN et BLFN de façon à compenser cette différence de courant.

Et, le courant I2 circulant dans la cellule CLS va permettre de recopier dans la cellule CLS, l'opposée de la donnée qui était stockée dans la cellule CEL (étape 43). En d'autres termes, le noeud haut de la cellule CLS est cette fois-ci le noeud F tandis que le noeud bas est le noeud T.

On délivre ensuite sur la grille des transistors PGT et PGN le signal SC1 de façon à rendre ces transistors passants (étape 44) et on extrait de la cellule CLS la donnée opposée qui est stockée.

Cette donnée opposée est par exemple stockée dans des moyens classiques et connus en soi, par exemple une mémoire-verrou (« latch », en langue anglaise).

Pour procéder à l'écriture d'une donnée dans la cellule CEL de la colonne COLi, le rôle des cellules CEL et CLS est inversé.

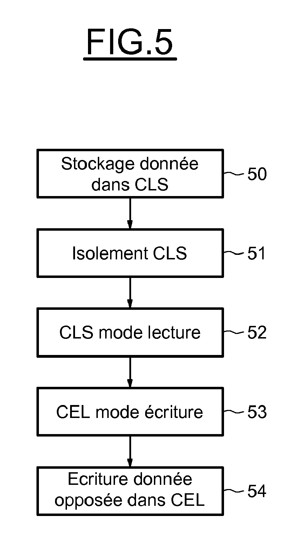

Ceci est illustré en particulier sur la figure 5.

On procède tout d'abord à un stockage de la donnée destinée à être écrite dans la cellule CEL, dans la cellule CLS. A cet égard, on rend passants les transistors PGT et PGN par l'intermédiaire des signaux de commande SC1, et l'on stocke la donnée dans la cellule CLS. On suppose par exemple que l'on va stocker, comme illustré sur la figure 3, un « 1 » au noeud F et un « 0 » au noeud T.

Puis, on isole la cellule CLS de l'extérieur en ouvrant (bloquant) les transistors PGT et PGN.

Ensuite, les lignes de bits BLTP et BLFP étant alimentées par la tension Vdd et les lignes de bits BLTN et BLFN portées à la masse, on applique sur la grille du transistor AXS de la cellule CLS une tension RWES de façon à placer cette cellule CLS dans son mode lecture, et on applique une tension RWEC sur la grille du transistor AXS de la cellule CEL de façon à la placer dans son mode d'écriture.

Dans cette configuration, la tension RWES est cette fois-ci inférieure à la tension RWEC. La tension RWES est ainsi une fraction de la tension Vdd tandis que la tension RWEC est cette fois-ci égale ou de préférence supérieure à la tension Vdd.

C'est donc cette fois-ci la cellule CEL qui est la moins stable. Le mécanisme décrit ci-avant pour l'écriture dans la cellule CLS est cette fois-ci celui utilisé pour l'écriture dans la cellule CEL.

A la fin de l'opération, la donnée opposée à celle contenue dans la cellule CLS est recopiée (écrite) dans la cellule CEL (étape 54).

Le fait que, de façon interne, il y ait un changement de valeur logique entre la donnée recopiée d'une cellule CEL dans la cellule supplémentaire CLS et inversement est sans importance. En effet, au final, on retrouvera la bonne donnée. En effet, si l'on veut écrire un « 1 » dans la cellule CEL, on va stocker un « 1 » dans la cellule CLS. Puis, un « 0 » sera recopié dans la cellule CEL. Mais, lorsqu'on lira la cellule CEL, on recopiera en fait un « 1 » dans la cellule CLS qui sera ensuite extrait de cette cellule CLS par les moyens d'accès supplémentaires PGT et PGN. Et on retrouve bien au final la valeur « 1 » que l'on avait souhaité stocker.

On voit donc que les opérations de lecture et d'écriture sont effectuées avec le même circuit, à savoir la cellule supplémentaire CLS, sans qu'il soit nécessaire d'utiliser un amplificateur de courant, ce qui résout le problème des offsets.

Par ailleurs, le courant de lecture d'une cellule est utilisé pour écrire dans la cellule supplémentaire et inversement, ce qui conduit à une consommation dynamique plus faible. Enfin, il n'y a aucune charge ni décharge des lignes de bits à chaque opération d'écriture.

Dans l'exemple qui vient d'être décrit, on a utilisé préférentiellement deux autres lignes de bits BLTN et BLFN qui sont tirées à la masse. Cela étant, il serait possible de ne pas utiliser ces lignes de bits supplémentaires et de connecter simplement les transistors M2 et M4 de chacune des cellules CEL ainsi que les transistors M20 et M40 de la cellule supplémentaire à la masse. Néanmoins, l'utilisation des lignes de bits supplémentaires BLTN et BLFN permet de favoriser davantage le changement d'état de la cellule CLS ou de la cellule CEL dans le mode d'écriture.

On a vu ci-avant qu'il était préférable d'appliquer une tension inférieure à la tension d'alimentation Vdd, par exemple une fraction de cette tension d'alimentation, sur la grille du transistor AXS d'une cellule lorsque l'on souhaitait que cette cellule soit en mode de lecture, tandis qu'il était préférable d'appliquer sur la grille du transistor AXS de cette cellule une tension plus élevée, par exemple une tension égale ou supérieure à la tension d'alimentation Vdd, lorsque l'on souhaite que cette cellule soit en mode d'écriture.

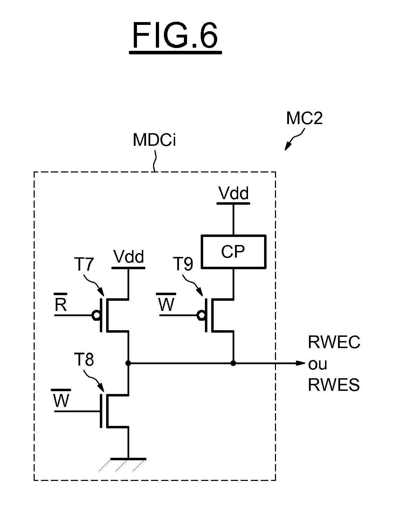

Dans ces conditions, on peut avantageusement utiliser pour chacune des cellules CEL ou CLS, un module de commande MDCi tel que celui illustré sur la figure 6. L'ensemble des modules MDCi forme les deuxièmes moyens de commande MC2.

Ce module de commande MDCi comporte une porte connectée entre la tension d'alimentation Vdd et la masse, et comportant un transistor PMOS T7 et un transistor NMOS T8. La sortie de cette porte est reliée à la grille du transistor AXS de la cellule correspondante.

La grille du transistor PMOS T7 est commandée par un signal logique de lecture R̅ tandis que la grille du transistor NMOS T8 est commandée par un signal logique d'écriture W̅ .

Le module MDCi comporte par ailleurs, dans cet exemple, un circuit de pompe de charge CP, de structure classique et connue en soi, connecté entre la tension d'alimentation Vdd et la grille du transistor d'accès AXS de la cellule correspondante par l'intermédiaire d'un transistor PMOS T9 commandé sur sa grille par le signal logique W̅.

Ainsi, lorsque l'on veut lire la cellule, on affecte la valeur logique « 1 » au signal R et la valeur logique « 0 » au signal W. Les transistors T7 et T8 sont par conséquent passants, le transistor T9 est bloqué, et il en résulte donc que la tension RWEC ou RWES est inférieure à la tension Vdd.

Lorsqu'on souhaite écrire dans la cellule, on affecte la valeur logique « 1 » au signal W et la valeur logique « 0 » au signal R, ce qui rend passant le transistor T9, bloqués les transistors T7 et T8, et fournit une tension RWEC ou RWES supérieure à la tension Vdd.

Par ailleurs, la porte T7, T8 permet de compenser les dispersions technologiques liées à la fabrication des transistors AXS. En effet, il est bien connu que certains transistors peuvent être plus rapides que d'autres. Et la porte permet ainsi de compenser le caractère rapide ou lent de ces transistors en mode lecture.

Plus précisément si l'on est dans une configuration technologique dans laquelle les transistors NMOS sont rapides et les transistors PMOS lents, la tension RWEC ou RWES délivrée en sortie de la porte va chuter plus fortement que si les transistors NMOS et PMOS présentaient la même rapidité car le transistor T8 est plus rapide que le transistor T7. Mais comme le transistor AXS est un transistor NMOS, donc rapide, cette rapidité est compensée par la chute de tension précitée.

A contrario, si l'on est dans une configuration technologique dans laquelle les transistors NMOS sont lents et les transistors PMOS rapides, la tension RWEC ou RWES délivrée en sortie de la porte va chuter moins fortement que si les transistors NMOS et PMOS présentaient la même rapidité car le transistor T7 est plus rapide que le transistor T8. Mais comme le transistor AXS est un transistor NMOS, donc lent, cette lenteur est compensée par la chute de tension précitée.

Dans le mode de réalisation de la figure 6, les deuxièmes moyens d'alimentation délivrant la tension de valeur supérieure à Vdd comportent la tension d'alimentation Vdd et un circuit de pompe de charge. Cela étant les deuxièmes moyens d'alimentation pourraient comporter uniquement une alimentation externe spécifique fournissant alors directement cette tension de valeur supérieure à Vdd.

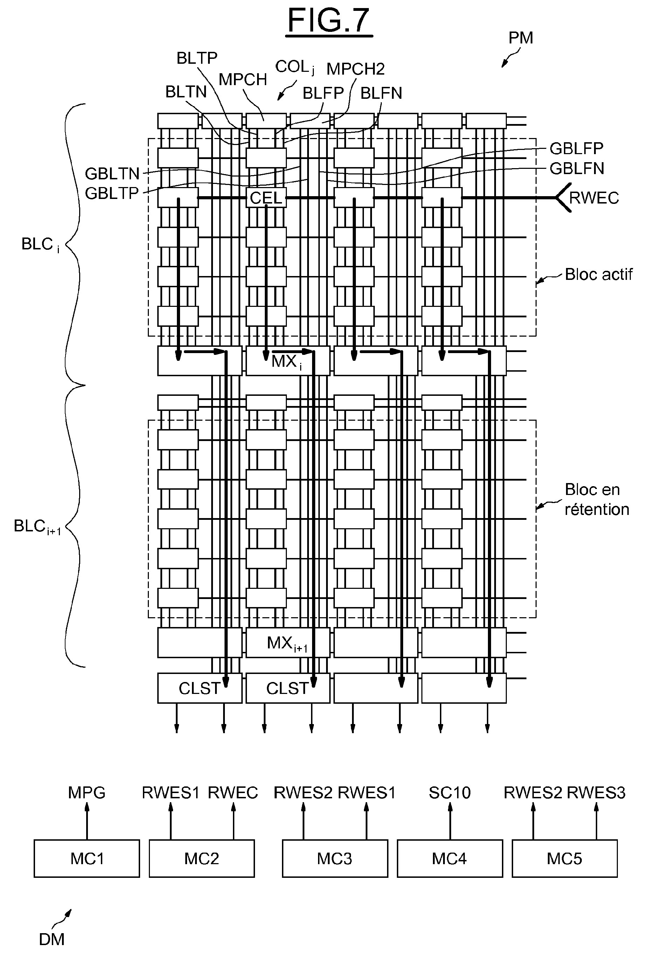

Dans le mode de réalisation illustré sur la figure 7, le plan mémoire (PM) comporte p blocs BLCᵢ de m colonnes et de n/p lignes. Il est ainsi possible de stocker n mots numériques de m bits chacun. Chaque mot est stocké dans une ligne de cellules-mémoire.

Chaque colonne COLⱼ d'un bloc a une structure identique à celle décrite en référence à la figure 3.

Plus précisément chaque colonne comporte comme on le verra plus en détails ci-après ladite cellule-mémoire supplémentaire connectée aux lignes de bits de la colonne, ici les deux lignes de bits BLTP et BLTN et les deux autres lignes de bits BLFP et BLFN.

Cette cellule-mémoire supplémentaire est contenue dans le module MXᵢ disposé à l'extrémité de la colonne.

A l'autre extrémité de la colonne sont disposé les moyens de précharge MPCH des lignes de bits.

Le plan-mémoire comporte également m paires de lignes de bits additionnelles, communément désignées par l'homme du métier sous le vocable anglo-saxon de « global bit lines », chaque paire de lignes additionnelles étant associée aux p colonnes homologues des p blocs. Des colonnes de blocs différents sont dites homologues lorsqu'elles ont le même rang j dans ces blocs.

Plus précisément, dans cet exemple, le plan-mémoire comporte, par analogie avec les doubles paires de lignes de bits, m doubles paires de lignes de bits additionnelles, à savoir pour la colonne de rang j illustrée, la paire de lignes de bits additionnelles GBLTP et GBLTN et la paire de lignes de bits additionnelles GBLFP et GBLFN.

Le plan-mémoire comporte également m deuxièmes cellules-mémoire supplémentaires associées à chaque bloc et respectivement contenues dans les m modules MXᵢ associés audit bloc BLCᵢ.

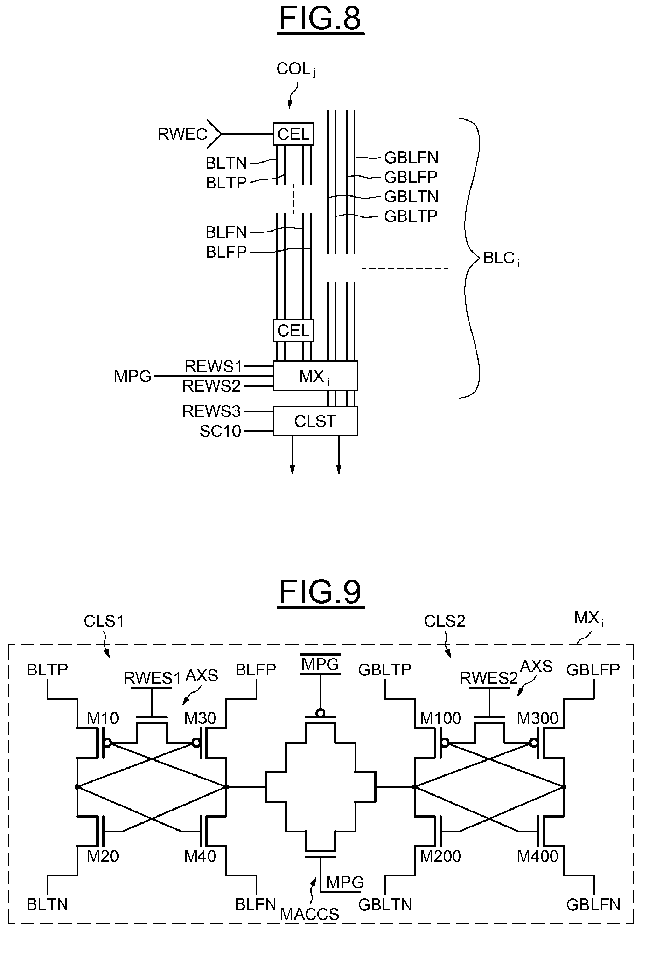

Chaque deuxième cellule-mémoire supplémentaire CLS2 (figure 9) a une structure identique à celle de ladite cellule-mémoire supplémentaire CLS1 connectée comme illustrée sur la figure 8, au bas de la colonne COLⱼ sur les lignes de bits BLFN, BLFP, BLTN, BLTP.

Par contre, comme illustré sur les figures 8 et 9, chaque deuxième cellule-mémoire supplémentaire est connectée à la double paire de lignes de bits additionnelles GBLFN, GBLFP, GBLTN, GBLTP.

Par ailleurs chaque deuxième cellule-mémoire supplémentaire CLS2 est connectée à la cellule-mémoire supplémentaire CLS1 correspondante par les moyens d'accès supplémentaires MACCS. Ces moyens d'accès supplémentaires MACCS comportent ici un transistor NMOS et un transistor PMOS en parallèle respectivement commandés sur leur grille par le signal de commande MPG et son complément.

Ainsi les moyens d'accès supplémentaires MACCS possèdent un premier état (interrupteur ouvert) dans lequel ils interdisent tout accès entre la cellule-mémoire supplémentaire CLS1 et la deuxième cellule-mémoire supplémentaire CLS2, et un deuxième état (interrupteur fermé) dans lequel ils autorisent un accès à chacune des deux cellules de façon à y stocker ou à y extraire une donnée et inversement.

La structure de la cellule-mémoire supplémentaire CLS1 est identique à celle de la cellule CLS de la figure 3. Les quatre transistors de cette cellule sont référencés M10, M20, M30, M40 et le transistor d'accès AXS est commandé par le signal de commande RWES1.

Le fonctionnement de cette cellule CLS1 en ce qui concerne l'écriture d'une donnée lue dans une cellule-mémoire de la colonne, ou bien la lecture d'une donnée dans cette cellule CLS1 en vue de son écriture dans une cellule-mémoire de la colonne, est identique à ce qui a été décrit précédemment.

Les quatre transistors de la cellule-mémoire CLS2 sont référencés M100, M200, M300, M400 et le transistor d'accès AXS est commandé par le signal de commande RWES2.

Les connexions de cette cellule CLS2 sur les lignes de bits additionnelles GBLFN, GBLFP, GBLTN, GBLTP sont identiques à celles de la cellule CLS1 (et de la cellule CLS de la figure 3) sur les lignes de bits BLFN, BLFP, BLTN, BLTP.

Le mode lecture et le mode écriture de cette cellule CLS2 sont fonctionnellement identiques à ce qui a été décrit en référence à la figure 3.

A cet égard les lignes de bits additionnelles GBLFN, GBLFP, GBLTN, GBLTP sont destinées à être préchargées par des moyens de précharge MPCH2 identiques aux moyens de précharge MPCH des lignes de bits.

Le plan-mémoire PM comporte également m cellules-supplémentaires terminales CLST, ayant chacune une structure identique à celle de chaque deuxième cellule-mémoire supplémentaire CLS2, respectivement connectées aux m doubles paires de lignes de bits additionnelles GBLFN, GBLFP, GBLTN, GBLTP.

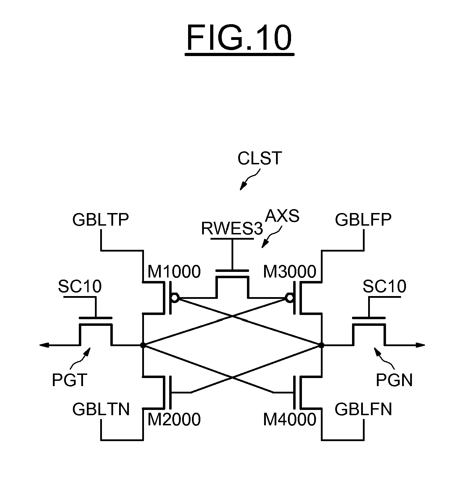

Plus précisément, comme illustré sur la figure 10, les quatre transistors de cette cellule CLST sont référencés M1000, M2000, M3000 et M4000 et le transistor d'accès AXS est commandé par le signal de commande RWES3.

Il est également prévu des moyens d'accès supplémentaires terminaux PGT, PGN commandables par le signal de commande SC10 et connectés à chaque cellule supplémentaire terminale CLST. Ces moyens d'accès supplémentaires terminaux PCT, PGT sont par exemple identiques aux moyens PGT et PGN connectés à la cellule-mémoire CLS de la figure 3.

Ainsi ces moyens d'accès supplémentaires terminaux PCT, PGT possèdent un premier état pour interdire un accès à la cellule supplémentaire terminale CLST et un deuxième état pour permettre un accès à la cellule supplémentaire terminale de façon à y stocker ou à en extraire une donnée.

Dans le dispositif des figures 7 à 10, les deuxièmes moyens de commande MC2 sont configurés pour, lorsque les moyens d'accès supplémentaires MACCS sont dans leur premier état, délivrer le premier signal de commande RWEC sur les grilles des transistors d'accès de toutes les cellules-mémoire CEL d'une même ligne d'un bloc BLCᵢ et le deuxième signal de commande RWES1 sur la grille du transistor d'accès de toutes les cellules-mémoire supplémentaires CLS1 dudit bloc de façon à placer lesdites cellules-mémoire CEL dans un mode de lecture et lesdites cellules-mémoire supplémentaires CLS1 dans un mode d'écriture, ou inversement.

Le dispositif comprend en outre des troisièmes moyens de commande MC3 configurés pour, lorsque les moyens d'accès supplémentaires MACCS sont dans leur deuxième état, délivrer le signal de commande RWES1 sur les grilles des transistors d'accès de toutes les cellules-mémoire supplémentaires CLS1 dudit bloc et le signal de commande RWES2 sur les grilles des transistors d'accès de toutes les deuxièmes cellules supplémentaires correspondantes CLS2 de façon à placer lesdites cellules-mémoire supplémentaires CLS1 dans un mode de lecture et lesdites deuxièmes cellules-mémoire supplémentaires CLS2 dans un mode d'écriture, ou inversement.

Des quatrièmes moyens de commande MC4 sont configurés pour délivrer le signal de commande SC10 de façon à placer lesdits moyens d'accès supplémentaires terminaux PGT, PGN dans leur premier ou dans leur deuxième état, et des cinquièmes moyens de commande MC5 sont configurés pour, lorsque les moyens d'accès supplémentaires terminaux PGT, PGN sont dans leur premier état, délivrer le signal de commande RWES2 sur la grille du transistor d'accès de chaque deuxième cellule-mémoire supplémentaire CLS2 associée à un bloc BLCᵢ et le signal de commande RWES3 sur la grille du transistor d'accès de chaque cellule-mémoire supplémentaire terminale CLST de façon à placer lesdites deuxièmes cellules-mémoire supplémentaires CLS2 dans un mode de lecture et lesdites cellules-mémoire supplémentaires terminales CLST dans un mode d'écriture, ou inversement.

Sur la figure 7, les différents moyens MC1-MC5 ont été différenciés. Cela étant certains au moins de ces moyens peuvent réalisés au sein d'un même module de commande, par exemple par des circuits logiques.

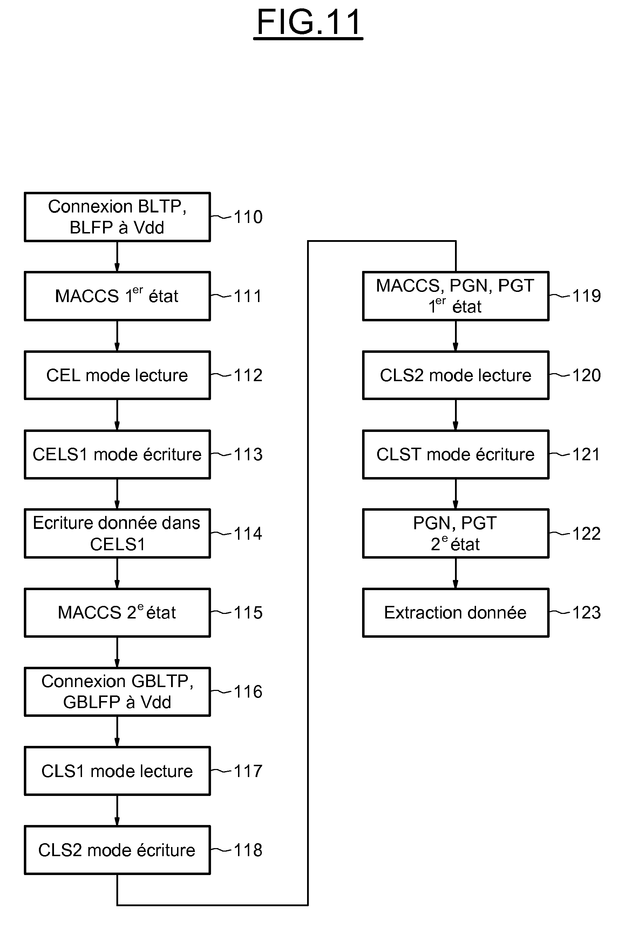

On va maintenant décrire en se référant à la figure 11 un exemple de lecture d'un groupe de données contenues dans une ligne de cellules-mémoire d'un bloc BLCᵢ du dispositif illustré sur les figures 7 à 10.

Cette lecture comprend une connexion 110 des deux lignes de bits BLTP, BLFP de chaque colonne à la tension d'alimentation Vdd, le placement 111 des moyens d'accès supplémentaires MACCS de chaque cellule-mémoire supplémentaire CLS1 dudit bloc dans leur premier état, le placement 112 de chaque cellule-mémoire CEL de ladite ligne dans son mode lecture et le placement 113 de chaque cellule-mémoire supplémentaire CLS1 dans son mode écriture.

L'opposée de la donnée contenue dans chaque cellule-mémoire CEL de la ligne est écrite (étape 114) dans la cellule-mémoire supplémentaire CLS1 correspondante.

Puis le placement 115 desdits moyens d'accès supplémentaires MACCS dans leur deuxième état est effectué.

On connecte les deux lignes de bits additionnelles GBLTP et GBLFP de chaque colonne à ladite tension d'alimentation (étape 116). On effectue le placement 117 de chaque cellule-mémoire supplémentaire CLS1 dudit bloc dans son mode lecture et le placement 118 de chaque deuxième cellule-mémoire supplémentaire CLS2 associée audit bloc dans son mode écriture.

L'opposée de la donnée contenue dans chaque cellule-mémoire supplémentaire CLS1 est écrite dans la deuxième cellule-mémoire supplémentaire CLS2 correspondante.

On place (étape 119) les moyens d'accès supplémentaires MACCS et les moyens d'accès supplémentaires terminaux PGN, PGT dans leur premier état.

On effectue le placement 120 de chaque deuxième cellule-mémoire supplémentaire CLS2 associée audit bloc BLCᵢ dans son mode lecture, et le placement 121 de chaque cellule-mémoire supplémentaire terminale CLST dans son mode écriture.

L'opposée de la donnée contenue dans chaque deuxième cellule-mémoire supplémentaire CLS2 est écrite dans la cellule-mémoire supplémentaire terminale CLST correspondante.

Puis on place (étape 122) les moyens d'accès supplémentaires terminaux PGT, PGN dans leur deuxième état et on procède à l'extraction 123 de ladite donnée contenue dans chaque cellule-mémoire supplémentaire terminale CLST.

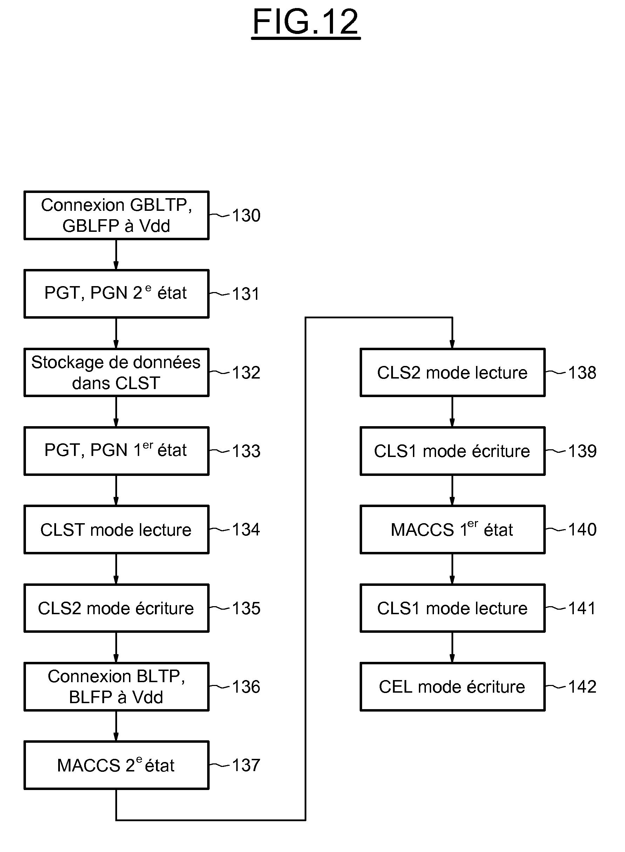

On se réfère maintenant à la figure 12 pour décrire un exemple d'écriture d'un groupe de données dans une ligne de cellules-mémoire d'un bloc BLCᵢ du dispositif illustré sur les figures 7 à 10.

Les étapes d'une telle écriture sont essentiellement les étapes inverses de celles qui viennent d'être décrites pour la lecture.

Ainsi une telle écriture comprend :
une connexion 130 des deux lignes de bits additionnelles GBLTP, GBLFP de chaque colonne à ladite tension d'alimentation,
le placement 131 des moyens d'accès supplémentaires terminaux PGT, PGN dans leur deuxième état,
le stockage 132 desdites données du groupe dans les cellules-mémoire supplémentaires terminales respectives CLST,
le placement 133 des moyens d'accès supplémentaires terminaux PGT, PGN et des moyens d'accès supplémentaires MACCS dudit bloc dans leur premier état,
le placement 134 des cellules-mémoire supplémentaires terminales CLST dans leur mode lecture et le placement 135 des deuxièmes cellules-mémoire supplémentaires CLS2 associées audit bloc dans leur mode écriture,
une connexion 136 des deux lignes de bits BLTP, BLFP de chaque colonne du bloc à la tension d'alimentation,
le placement 137 desdits moyens d'accès supplémentaires MACCS du bloc dans leur deuxième état,
le placement 138 de chaque deuxième cellule-mémoire supplémentaire CLS2 associée audit bloc dans son mode lecture et le placement 139 de chaque cellule-mémoire supplémentaire correspondante CLS1 dans son mode écriture,
le placement 140 desdits moyens d'accès supplémentaires MACCS du bloc dans leur premier état,
le placement 141 de chaque cellule-mémoire supplémentaire CLS1 dudit bloc dans son mode lecture et le placement 142 de chaque cellule-mémoire de ladite ligne dans son mode écriture.

Dans les modes de réalisation et de mise en oeuvre qui viennent d'être décrits en référence aux figures 7 à 12, lorsque une ligne doit être écrite ou lue, seuls les modules MXi du bloc BLCi contenant ladite ligne sont concernés par ces opérations. Les autres cellules-mémoire des autres blocs peuvent être dans un mode de rétention (figure 7), c'est-à-dire avec une faible tension d'alimentation, de façon à avoir moins de fuite.

Ces modes de réalisation et de mise en oeuvre offrent donc l'avantage, contrairement aux architectures classiques des plans-mémoire du type SRAM avec des cellules à 6 transistors, de présenter une faible consommation dynamique et de ne pas perturber les cellules-mémoire en rétention.

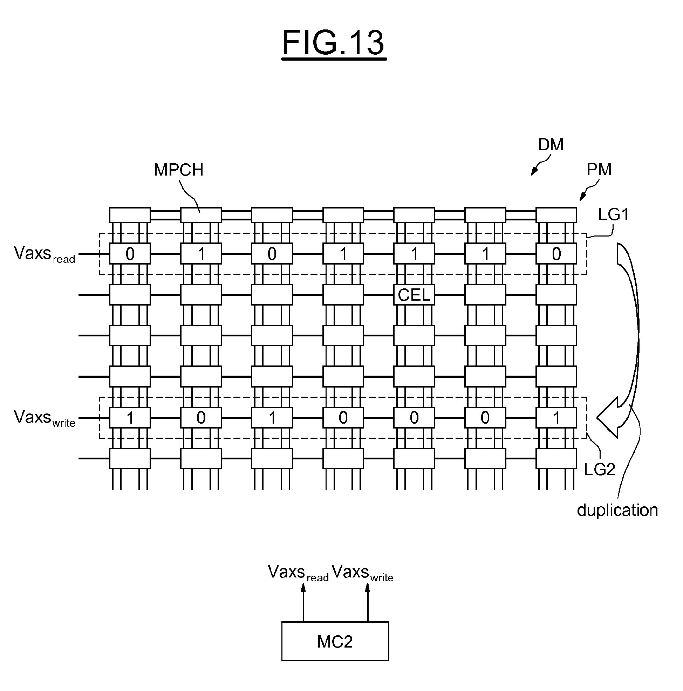

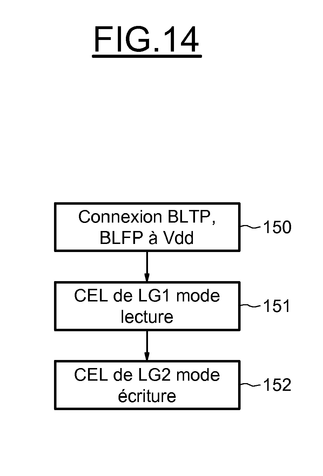

On va maintenant décrire en se référant plus particulièrement aux figures 13 et 14, une autre application des placements des cellules-mémoire dans leur mode lecture ou dans leur mode écriture.

Il s'agit de la duplication du contenu d'une ligne du plan-mémoire dans une autre ligne du plan mémoire. A cet égard il n'est pas nécessaire pour une telle application que le plan-mémoire contienne des cellules-mémoire supplémentaires telles que par exemple celle illustrée sur la figure 3.

Plus précisément selon un mode de réalisation très général, le dispositif de mémoire du type SRAM, comprend un plan mémoire PM possédant au moins une colonne COL de cellules-mémoire CEL du type SRAM comportant deux inverseurs couplés de façon croisée et un seul transistor d'accès, chaque cellule-mémoire CEL étant connectée entre deux lignes de bits BLTP, BLFP sans transistors d'accès. Selon une caractéristique générale de ce mode de réalisation les deux lignes de bits BLTP, BLFP sont destinées à être alimentées par une tension d'alimentation Vdd. Le dispositif comprend en outre des moyens de contrôle MC2 configurés pour délivrer un premier signal de contrôle sur la grille du transistor d'accès d'une première cellule-mémoire de la colonne et un deuxième signal de contrôle sur la grille du transistor d'accès d'une deuxième cellule-mémoire de la colonne de façon à placer ladite première cellule-mémoire dans un mode de lecture et ladite deuxième cellule-mémoire dans un mode d'écriture, ou inversement.

La figure 13 illustre le cas où le plan-mémoire comporte plusieurs colonnes.

Dans ce cas il est possible de recopier en une seule fois et en un seul cycle d'horloge le contenu d'une ligne, ou plus exactement l'opposé de ce contenu, dans une autre ligne. Cela étant, cette recopie peut également ne pas être synchrone avec un cycle d'horloge lorsqu'elle est effectuée par exemple en réponse à un signal asynchrone (signal évènement).

Ainsi une telle recopie comprend (figure 14) une connexion 150 des lignes de bits BLTP, BLFP de chaque colonne à la tension d'alimentation Vdd, le placement 151 des cellules-mémoire d'une première ligne LG1 dans leur mode lecture et le placement 152 des cellules-mémoire d'une deuxième ligne LG2 dans leur mode écriture.

Comme expliqué ci-avant, le placement des cellules-mémoire d'une première ligne dans leur mode lecture comprend l'application sur les grilles des transistors AXS de ces cellules d'une tension Vaxs_{read} égale à une fraction de la tension d'alimentation, et l'application sur les grilles des transistors AXS des cellules de la deuxième ligne d'une tension Vaxs_{write} égale à la tension d'alimentation.

Bien entendu la structure des moyens de contrôle MC2 peut être identique à la structure des moyens de commande MC2 décrits en référence aux figures 3 et 6.

La duplication de lignes au sein du plan mémoire permet par exemple de rendre plus robuste le contenu de la mémoire vis-à-vis de la corruption de données dans une ligne, et peut également trouver des applications dans des domaines variés, tels que par exemple les registres à décalage, les chaînes de test (« scan chain »).

## Revendications

1. Dispositif de mémoire du type SRAM, comprenant un plan mémoire (PM) possédant au moins une colonne (COL) de cellules-mémoire (CEL) du type SRAM comportant deux inverseurs couplés de façon croisée et un seul transistor d'accès, chaque cellule-mémoire (CEL) étant connectée entre deux lignes de bits (BLTP, BLFP) sans transistors d'accès, **caractérisé en ce que** chaque colonne du plan-mémoire comporte en outre une cellule supplémentaire (CLS), de structure identique aux cellules-mémoires (CEL) de ladite colonne, connectée aux deux lignes de bits, **en ce que** les deux lignes de bits (BLTP, BLFP) sont destinées à être alimentées par une tension d'alimentation (Vdd), et **en ce que** le dispositif comprend en outre des moyens d'accès supplémentaires (PGT, PGN) commandables connectés à ladite cellule supplémentaire (CLS) et possédant un premier état pour interdire un accès à ladite cellule supplémentaire et un deuxième état pour permettre un accès à ladite cellule supplémentaire de façon à y stocker ou à en extraire une donnée, des premiers moyens de commande (MC1) configurés pour placer lesdits moyens d'accès supplémentaires dans leur premier ou dans leur deuxième état, et des deuxièmes moyens de commande (MC2) configurés pour, lorsque les moyens d'accès supplémentaires sont dans leur premier état, délivrer un premier signal de commande sur la grille du transistor d'accès de l'une des cellules-mémoire de la colonne et un deuxième signal de commande sur la grille du transistor d'accès de la cellule supplémentaire de façon à placer ladite cellule-mémoire dans un mode de lecture et la cellule-mémoire supplémentaire dans un mode d'écriture, ou inversement.

2. Dispositif selon la revendication 1, dans lequel les deuxièmes moyens de commande (MC2) sont configurés pour délivrer sur la grille du transistor d'accès (AXS) de ladite cellule-mémoire (CEL), une première tension (RWEC) en tant que premier signal de commande de façon à rendre passant ce transistor d'accès, et pour délivrer sur la grille du transistor d'accès (AXS) de ladite cellule-mémoire supplémentaire (CLS), une deuxième tension (RWES) en tant que deuxième signal de commande de façon à rendre passant ce transistor d'accès, la première tension étant inférieure à la deuxième tension de façon à placer la cellule-mémoire dans le mode lecture et la cellule-mémoire supplémentaire dans le mode écriture, et la première tension étant supérieure à la deuxième tension de façon à placer la cellule-mémoire dans le mode écriture et la cellule-mémoire supplémentaire dans le mode lecture.

3. Dispositif selon la revendication 1 ou 2, dans lequel les deuxièmes moyens de commande (MC2) comprennent des modules de commande (MDCi) respectivement associés aux cellules-mémoire de la colonne et à la cellule-mémoire supplémentaire, chaque module de commande comportant une porte (T7, T8) connectée entre la tension d'alimentation et la masse et comportant un transistor PMOS et un transistor NMOS connectés en série, la sortie de la porte étant connectée à la grille du transistor d'accès (AXS) de la cellule-mémoire correspondante, et les grilles des deux transistors de la porte étant respectivement commandées par un signal logique de lecture (R̅) et un signal logique d'écriture (W̅), et des deuxièmes moyens d'alimentation configurés pour délivrer une deuxième tension d'alimentation de valeur supérieure à celle (Vdd) de ladite tension d'alimentation, et connectés à la grille dudit transistor d'accès par l'intermédiaire d'un transistor auxiliaire (T9) commandé sur sa grille par le signal logique d'écriture (W̅).

4. Dispositif selon la revendication 3, dans lequel les deuxièmes moyens d'alimentation comportent une pompe de charge (CP) connectée entre la tension d'alimentation et la grille dudit transistor d'accès.

5. Dispositif selon l'une des revendications précédentes, dans lequel chaque inverseur d'une cellule-mémoire et de la cellule-mémoire supplémentaire est connecté entre l'une des deux lignes de bit et une autre ligne de bit (BLTN, BLFN) destinée à être connectée à la masse.

6. Dispositif selon l'une des revendications 1 à 5, dans lequel le plan mémoire (PM) comporte plusieurs colonnes.

7. Dispositif selon la revendication 6, dans lequel le plan mémoire (PM) comporte
p blocs (BLCᵢ) de m colonnes et de n/p lignes, chaque colonne d'un bloc comportant ladite cellule supplémentaire (CLS1) connectée auxdites deux lignes de bits de la colonne,
m paires de lignes de bits additionnelles (GBLTP, GBLFP), chaque paire de lignes additionnelles étant associée aux p colonnes homologues des p blocs,
m deuxièmes cellules-mémoire supplémentaires (CLS2) associées à chaque bloc, de structure identique à celle de ladite cellule-mémoire supplémentaire, respectivement connectées aux m paires de lignes de bits additionnelles et respectivement connectées aux m cellules-mémoire supplémentaires (CLS1) du bloc correspondant par lesdits moyens d'accès supplémentaires (MACCS), et
m cellules-supplémentaires terminales (CLST), ayant chacune une structure identique à celle de chaque deuxième cellule-mémoire supplémentaire, respectivement connectées aux m paires de lignes de bits additionnelles,
dispositif dans lequel les deuxièmes moyens de commande (MC2) sont configurés pour, lorsque les moyens d'accès supplémentaires (MACCS) sont dans leur premier état, délivrer un premier signal de commande sur les grilles des transistors d'accès de toutes les cellules-mémoire (CEL) d'une même ligne d'un bloc et un deuxième signal de commande sur la grille du transistor d'accès de toutes les cellules-mémoire supplémentaires (CLS1) dudit bloc de façon à placer lesdites cellules-mémoire dans un mode de lecture et lesdites cellules-mémoire supplémentaires dans un mode d'écriture, ou inversement, et
le dispositif comprend en outre
des troisièmes moyens de commande (MC3) configurés pour, lorsque les moyens d'accès supplémentaires (MACCS) sont dans leur deuxième état, délivrer un premier signal de commande sur les grilles des transistors d'accès de toutes les cellules-mémoire supplémentaires dudit bloc et un deuxième signal de commande sur les grilles des transistors d'accès de toutes les deuxièmes cellules supplémentaires correspondantes de façon à placer lesdites cellules-mémoire supplémentaires (CLS1) dans un mode de lecture et lesdites deuxièmes cellules-mémoire supplémentaires (CLS2) dans un mode d'écriture, ou inversement,
des moyens d'accès supplémentaires terminaux (PGT, PGN) commandables connectés à chaque cellule supplémentaire terminale (CLST) et possédant un premier état pour interdire un accès à chaque cellule supplémentaire terminale et un deuxième état pour permettre un accès à chaque cellule supplémentaire terminale de façon à y stocker ou à en extraire une donnée,
des quatrièmes moyens de commande (MC4) configurés pour placer lesdits moyens d'accès supplémentaires terminaux dans leur premier ou dans leur deuxième état, et
des cinquièmes moyens de commande (MC5) configurés pour, lorsque les moyens d'accès supplémentaires terminaux sont dans leur premier état, délivrer un premier signal de commande sur la grille du transistor d'accès de chaque deuxième cellule-mémoire supplémentaire associé à un bloc et un deuxième signal de commande sur la grille du transistor d'accès de chaque cellule-mémoire supplémentaire terminale de façon à placer lesdites deuxièmes cellules-mémoire supplémentaires dans un mode de lecture et lesdites cellules-mémoire supplémentaires terminales dans un mode d'écriture, ou inversement.

8. Dispositif de mémoire du type SRAM, comprenant un plan mémoire (PM) possédant au moins une colonne (COL) de cellules-mémoire (CEL) du type SRAM comportant deux inverseurs couplés de façon croisée et un seul transistor d'accès, chaque cellule-mémoire (CEL) étant connectée entre deux lignes de bits (BLTP, BLFP) sans transistors d'accès, **caractérisé en ce que** les deux lignes de bits (BLTP, BLFP) sont destinées à être alimentées par une tension d'alimentation (Vdd), et **en ce que** le dispositif comprend en outre des moyens de contrôle (MC2) configurés pour délivrer un premier signal de contrôle sur la grille du transistor d'accès d'une première cellule-mémoire de la colonne et un deuxième signal de contrôle sur la grille du transistor d'accès d'une deuxième cellule-mémoire de la colonne de façon à placer ladite première cellule-mémoire dans un mode de lecture et ladite deuxième cellule-mémoire dans un mode d'écriture, ou inversement.

9. Dispositif selon la revendication 8, dans lequel les moyens de contrôle (MC2) sont configurés pour délivrer sur la grille du transistor d'accès (AXS) de ladite première cellule-mémoire (CEL), une première tension (RWEC) en tant que premier signal de commande de façon à rendre passant ce transistor d'accès, et pour délivrer sur la grille du transistor d'accès (AXS) de ladite deuxième cellule-mémoire (CLS), une deuxième tension (RWES) en tant que deuxième signal de commande de façon à rendre passant ce transistor d'accès, la première tension étant inférieure à la deuxième tension de façon à placer la première cellule-mémoire dans le mode lecture et la deuxième cellule-mémoire dans le mode écriture, et la première tension étant supérieure à la deuxième tension de façon à placer la première cellule-mémoire dans le mode écriture et la deuxième cellule-mémoire dans le mode lecture.

10. Dispositif selon la revendication 8 ou 9, dans lequel les moyens de contrôle (MC2) comprennent des modules de commande (MDCi) respectivement associés aux cellules-mémoire de la colonne, chaque module de commande comportant une porte (T7, T8) connectée entre la tension d'alimentation et la masse et comportant un transistor PMOS et un transistor NMOS connectés en série, la sortie de la porte étant connectée à la grille du transistor d'accès (AXS) de la cellule-mémoire correspondante, et les grilles des deux transistors de la porte étant respectivement commandées par un signal logique de lecture (R̅) et un signal logique d'écriture (W̅), et une pompe de charge (CP) connectée entre la tension d'alimentation et la grille dudit transistor d'accès par l'intermédiaire d'un transistor auxiliaire (T9) commandé sur sa grille par le signal logique d'écriture (W̅).

11. Dispositif selon l'une des revendications 8 à 10, dans lequel chaque inverseur d'une cellule-mémoire est connecté entre l'une des deux lignes de bit et une autre ligne de bit (BLTN, BLFN) destinée à être connectée à la masse.

12. Dispositif selon l'une des revendications précédentes, dans lequel le plan mémoire (PM) comporte plusieurs colonnes.

13. Procédé de lecture d'une donnée contenue dans une cellule-mémoire d'un dispositif selon l'une des revendications 1 à 6, comprenant une connexion des deux lignes de bits à ladite tension d'alimentation, le placement (40) des moyens d'accès supplémentaires de la cellule-mémoire supplémentaire dans leur premier état, le placement (41) de la cellule-mémoire dans son mode lecture, le placement (42) de la cellule-mémoire supplémentaire dans son mode écriture, l'opposée de la donnée contenue dans ladite cellule-mémoire étant écrite (43) dans la cellule-mémoire supplémentaire, le placement (44) des moyens d'accès supplémentaires dans leur deuxième état, et l'extraction (45) de ladite donnée opposée de ladite cellule-mémoire supplémentaire.

14. Procédé d'écriture d'une donnée dans une cellule-mémoire d'un dispositif selon l'une des revendications 1 à 6, comprenant une connexion des deux lignes de bits à ladite tension d'alimentation, le placement des moyens d'accès supplémentaires de la cellule-mémoire supplémentaire dans leur deuxième état, le stockage (50) de ladite donnée dans la cellule-mémoire supplémentaire, le placement (51) des moyens d'accès supplémentaires dans leur premier état, le placement (CLS) de la cellule-mémoire dans son mode écriture, le placement (53) de la cellule-mémoire supplémentaire dans son mode lecture, l'opposée de la donnée contenue dans ladite cellule-mémoire supplémentaire étant écrite dans la cellule-mémoire.

15. Procédé de lecture d'un groupe de données contenues dans une ligne de cellules-mémoire d'un bloc du dispositif selon la revendication 7, comprenant une connexion (110) des deux lignes de bits de chaque colonne à ladite tension d'alimentation, le placement (111) des moyens d'accès supplémentaires de chaque cellule-mémoire supplémentaire dudit bloc dans leur premier état, le placement (112) de chaque cellule-mémoire de ladite ligne dans son mode lecture, le placement (113) de chaque cellule-mémoire supplémentaire dans son mode écriture, l'opposée de la donnée contenue dans chaque cellule-mémoire étant écrite (114) dans la cellule-mémoire supplémentaire correspondante, le placement (115) desdits moyens d'accès supplémentaires dans leur deuxième état, une connexion (116) des deux lignes de bits additionnelles de chaque colonne à ladite tension d'alimentation, le placement (117) de chaque cellule-mémoire supplémentaire dudit bloc dans son mode lecture, le placement (118) de chaque deuxième cellule-mémoire supplémentaire associée audit bloc dans son mode écriture, l'opposée de la donnée contenue dans chaque cellule-mémoire supplémentaire étant écrite dans la deuxième cellule-mémoire supplémentaire correspondante, le placement (119) desdits moyens d'accès supplémentaires et des moyens d'accès supplémentaires terminaux dans leur premier état, le placement (120) de chaque deuxième cellule-mémoire supplémentaire associée audit bloc dans son mode lecture, le placement (121) de chaque cellule-mémoire supplémentaire terminale dans son mode écriture, l'opposée de la donnée contenue dans chaque deuxième cellule-mémoire supplémentaire étant écrite dans la cellule-mémoire supplémentaire terminale correspondante, le placement (122) des moyens d'accès supplémentaires terminaux dans leur deuxième état et l'extraction (123) de ladite donnée contenue dans chaque cellule-mémoire supplémentaire terminale.

16. Procédé d'écriture d'un groupe de données dans une ligne de cellules-mémoire d'un bloc du dispositif selon la revendication 7, comprenant une connexion (130) des deux lignes de bits additionnelles de chaque colonne à ladite tension d'alimentation, le placement (131) des moyens d'accès supplémentaires terminaux dans leur deuxième état, le stockage (132) desdites données du groupe dans les cellules-mémoire supplémentaires terminales respectives, le placement (133) des moyens d'accès supplémentaires terminaux et des moyens d'accès supplémentaires dudit bloc dans leur premier état, le placement (134) des cellules-mémoire supplémentaires terminales dans leur mode lecture et le placement (135) des deuxièmes cellules-mémoire supplémentaires associées audit bloc dans leur mode écriture, une connexion (136) des deux lignes de bits de chaque colonne du bloc à la tension d'alimentation, le placement (137) desdits moyens d'accès supplémentaires du bloc dans leur deuxième état, le placement (138) de chaque deuxième cellule-mémoire supplémentaire associée audit bloc dans son mode lecture et le placement (139) de chaque cellule-mémoire supplémentaire correspondante dans son mode écriture, le placement (140) desdits moyens d'accès supplémentaires du bloc dans leur premier état, le placement (141) de chaque cellule-mémoire supplémentaire dudit bloc dans son mode lecture et le placement (142) de chaque cellule-mémoire de ladite ligne dans son mode écriture.

17. Procédé de recopie du contenu d'une première ligne du plan-mémoire dans une deuxième ligne du plan-mémoire du dispositif selon les revendications 8 et 12, comprenant une connexion (150) des lignes de bits de chaque colonne à une tension d'alimentation, le placement (151) des cellules-mémoire de ladite première ligne (LG1) dans leur mode lecture et le placement (152) des cellules-mémoire de ladite deuxième ligne (LG2) dans leur mode écriture.
